# EUROPEAN PATENT SPECIFICATION

(11) **EP 4 177 614 B1**
(45) Date of publication and mention of the grant of the patent: **25.06.2025**
(21) Application number: 21207048.6
(22) Date of filing: 09.11.2021
(51) Int. Cl.: G01R 15/16, H01R 13/53, H01B 17/28, H02G 15/107, H01B 17/00, H01B 17/26, H01R 13/66, H02G 15/072

(54) **SENSORED BUSHING**
MIT SENSOREN BESTÜCKTE BUCHSE
DOUILLE À CAPTEUR

(43) Date of publication of application: 10.05.2023
(73) Proprietor: 3M Innovative Properties Company, Saint Paul, MN 55133-3427 (US)
(72) Inventor: Stollwerck, Gunther, 47802 Krefeld (DE); Gravermann, Mark, 41812 Erkelenz (DE)
(74) Representative: Müller, Bruno

(56) References cited:
- EP-A1- 3 910 346
- US-A- 3 769 447
- US-A- 3 967 051
- US-A1- 2017 234 908

## Description

The present disclosure relates to bushings for connecting separable connectors to switchgears or to transformers in power distribution networks for distributing electrical power at medium or high voltages. It relates in particular to such bushings that comprise elements of a voltage sensor, and to processes for manufacturing such bushings.

In a medium-voltage or high-voltage power distribution network, a power cable is typically connected to network apparatus, such as switchgears or transformers, via a bushing that extends from inside the apparatus through an electrically grounded wall to outside the apparatus and has a bushing conductor which is embedded in an insulating bushing body. A separable connector, also often referred to as a removable power connector, mounted at the end of the cable, can be mechanically and electrically connected to the bushing, so that power can be conducted from the power cable through the bushing into the apparatus.

Elements of a voltage sensor for measuring the voltage of the bushing conductor - and thereby the voltage of the power cable - can be integrated into the bushing, making it a "sensored bushing". A voltage sensor of that general type is described, for example, in the European patent EP 2 740 129 B1.

Many such voltage sensors use a voltage divider (a "sensing voltage divider") to sense the elevated voltage of the bushing conductor. Advantageously a high-voltage capacitor (also referred to as a "primary capacitor" herein), or the entire high-voltage portion, of the sensing voltage divider is accommodated in the bushing, making use of the insulative properties of the bushing body, which typically comprises a solidified casting material. In certain bushings of this type, a grounded shield electrode envelopes the electrodes of the primary capacitor to reduce the influence of external electrical fields on the sensing electrode and the associated loss of sensing accuracy. In some of these bushings a portion of the casting material insulates the electrodes of the primary capacitor against the shield electrode.

Embedding capacitor electrodes in a solidified casting material, e.g. in the casting material of a body of a sensored bushing, is a known method of obtaining a strong electrical insulation and adequate mechanical rigidity of the bushing. When manufacturing such a bushing, a liquid, viscous casting material flows around the bushing conductor and the pre-positioned electrodes in a mold and fills all available space. The casting material is then caused to cure and thereby solidify to form the body of the bushing in which the bushing conductor and the electrodes are embedded.

Where two electrodes are insulated from each other by a portion of the casting material, these electrodes traditionally had to be separately and consecutively placed into mold and had to be firmly held in the desired spatial relation during molding to avoid displacements by the flow of casting material. If the flow of casting material displaced one electrode, the resulting electrode assembly would not be concentric or symmetric after solidification, resulting in a loss of sensing precision of the voltage sensor and in a higher risk of electrical discharges. Separately placing the two electrodes in the mold was time-consuming, and a separate temporary holding mechanism had to be provided to keep the electrodes in their precise desired arrangement during the molding process. United States patent US 3,967,051 describes a cast bushing having a capacitor structure which includes concentrically positioned capacitor sections, each of which includes a spacing member which helps to maintain the distance between the conducting portions of the capacitor sections during the casting process. In United States patent US 3,769,447, polycarbonate cylindrical members for supporting conductive elements of a condenser bushing are arranged concentrically and are maintained spaced from each other by spacers formed as dimples. The European patent application EP 3910346 A1 refers to a bushing in which, prior to molding to form an insulating body, sensor electrodes may be mechanically coupled by coaxial annular insulating members (e.g., O-rings, such as PTFE O-rings) to form an integrated module that facilitates maintaining a desired spacing between sensor electrodes during the subsequent molding or casting process.

There is a need for bushings with a true electrode geometry closer to the design geometry, as well as a more precise orientation and spacing of their electrodes relative to each other. It is also desirable that electrodes are in their desired spatial relation with respect to each other after the molding process. These needs are addressed by the sensored bushing defined in claim 1 and its corresponding manufacturing method defined in claim 14. Further embodiments are defined in their corresponding dependent claims. The description and drawings also present additional aspects, implementations, examples, non-claimed embodiments, etc... for the better understanding of the embodiments defined in the appended claims. In this respect, the invention is defined by the claims.

In an attempt to address these needs, the present disclosure provides in a first fundamental aspect a sensored bushing for connecting a separable connector to a switchgear or to a transformer in a power distribution network of a national grid for distributing electrical power at medium or high voltages, the bushing comprising
a) a bushing body comprising a solidified, electrically insulating casting material;
b) an elongated bushing conductor, embedded in the casting material, for conducting power at an elevated voltage and at currents of ten Ampère or more into the switchgear or the transformer, the length direction of the bushing conductor defining a bushing axis and axial directions and radial directions orthogonal to the bushing axis;
c) a tubular sensing electrode, embedded in the casting material and arranged coaxially around the bushing conductor,
   wherein the sensing electrode and the bushing conductor are operable as electrodes of a primary capacitor, a dielectric of the primary capacitor being formed by a first portion of the casting material arranged between the sensing electrode and the bushing conductor, wherein the primary capacitor is operable as a high-voltage capacitor in a high-voltage portion of a sensing voltage divider for sensing the elevated voltage of the bushing conductor;
d) a tubular shield electrode, embedded in the casting material, arranged coaxially around the sensing electrode, and insulated against the sensing electrode by a second portion of the casting material arranged between the sensing electrode and the shield electrode;
e) a first spacer, embedded in the casting material and arranged radially between the sensing electrode and the shield electrode,
wherein the first spacer is mechanically connected to the sensing electrode and to the shield electrode to maintain the sensing electrode and the shield electrode in a fixed spatial relation to each other, wherein the first spacer comprises a flat major surface and is oriented such that a normal on the major surface is oriented parallel to a central axis of the tubular sensing electrode or to a central axis of the tubular shield electrode.

The spacer keeps the electrodes in a fixed spatial relation during the molding process, when liquid casting material flows into the mold. Casting materials often flow into a mold at high speed and under pressure, so that the kinetic energy of the flow of casting material tends to deform an electrode, and/or tends to displace one electrode with respect to the other or with respect to the bushing conductor. Both effects are potentially detrimental to the structural integrity of the electrode assembly (i.e. the assembly consisting of the sensing electrode, the shield electrode and the first spacer), to the avoidance of electrical discharges in use and to the precision of the voltage sensing performed by the sensing electrode. The spacer reduces the risk of deformation of the electrodes during molding, during solidification and thereafter, because it imparts additional rigidity to the electrode assembly. The spacer also reduces the risk of displacement of one electrode relative to the other during molding, during solidification and thereafter, because it connects the electrodes mechanically and keeps them concentric and at a fixed radial distance between them.

The present disclosure relates to bushings and sensing voltage dividers for use in medium-voltage (MV) or high-voltage (HV) power distribution networks in which electrical power is distributed via HV/MV power cables, transformers, switchgears, substations etc. with currents of tens or hundreds of amperes and voltages of tens of kilovolts. The expression "medium voltage" or "MV" as used herein refers to AC voltages in the range of 1 kilovolt ("kV") to 72 kV, whereas the expression "high voltage" or "HV" refers to AC voltages of more than 72 kV. Medium voltage and high voltage are collectively referred to herein as "elevated voltage".

The bushing conductor is elongated. It may have, for example, the shape of a cylindrical rod. Its length direction defines axial directions of the bushing. Radial directions of the bushing are directions orthogonal to the axial directions.

Bushings according to the present disclosure are useful for sensing an elevated voltage in a power distribution network with high accuracy. In particular the sensing electrode may form an electrode of an integrated primary capacitor in the bushing which is useful as a high-voltage capacitor in the high-voltage portion of a sensing voltage divider for sensing the elevated voltage of the bushing conductor. The integrated primary capacitor of a bushing according to the present disclosure may be used as the only capacitor in the high-voltage portion of a sensing voltage divider, e.g. as the only capacitor in a sensing voltage divider which comprises a single capacitor in its high-voltage portion.

In certain embodiments, a bushing according to the present disclosure is connected electrically and mechanically to an element such as a separable connector or a cable conductor, wherein the element is on elevated voltage. A sensing voltage divider is used to sense the elevated voltage of the element to a certain degree of precision, e.g. ±10% or ±5% or ±1% or ±0,5% or ±0,2% precision. The sensing voltage divider can comprise the primary capacitor of a bushing as described herein, wherein the sensing electrode and the bushing conductor form the electrodes of the primary capacitor, and a portion of the solidified casting material forms the dielectric of the primary capacitor.

As used herein, a high-voltage portion of a voltage divider is the electrical portion that is electrically arranged between a signal contact, at which a divided voltage can be picked up, and the elevated voltage which is to be sensed. The low-voltage portion of a voltage divider is the portion that is electrically arranged between that signal contact and electrical ground.

The sensing voltage divider may be a capacitive voltage divider. In a capacitive voltage divider, the high-voltage portion comprises one or more capacitors ("high-voltage capacitors"), and the low-voltage portion comprises one or more capacitors ("low-voltage capacitors"). The primary capacitor of the bushing according to the present disclosure is one of the high-voltage capacitors. Where the high-voltage portion comprises only one high-voltage capacitor, the primary capacitor of the bushing according to the present disclosure is this high-voltage capacitor of the sensing voltage divider.

In certain embodiments a sensored bushing according to the present disclosure comprises one low-voltage capacitor, or a plurality of low-voltage capacitors. Instead of a single low-voltage capacitor, a plurality of low-voltage capacitors may be electrically connected in parallel in order to obtain a desired low-voltage capacitance, e.g. in order to arrive at a target dividing ratio of the sensing voltage divider. A low-voltage capacitor may be a discrete capacitor or an integrated capacitor. Sensored bushings comprising one or more discrete low-voltage capacitors may be more easily adapted to a desired dividing ratio or to a desired signal voltage by picking one or more discrete low-voltage capacitors of a suitable capacitance than sensored bushings comprising an integrated low-voltage capacitor. The capacitance of integrated low-voltage capacitors can generally not be changed without affecting the structure of the bushing.

The low-voltage capacitor(s) may be arranged in the bushing or on the bushing, or remote from the bushing. The low-voltage capacitor(s) may, for example, be embedded in the casting material or attached to an outer surface of the bushing body. It may be advantageous for the bushing to comprise the low-voltage capacitor(s) because this may increase reliability of the sensing voltage divider, since no error-prone external wire connection between the primary capacitor and the low-voltage capacitor(s) is required and the connection between the primary capacitor and the low-voltage capacitor(s) may be shorter and hence be less likely to pick up noise.

The sensing electrode of a bushing according to the present disclosure is tubular. It may have, for example, a cylindrical shape, i.e. the shape of the curved surface of a cylinder. The tubular sensing electrode may have, for example, a circular cross section or an elliptical cross section or a rectangular or square cross section. The tubular sensing electrode may have an aspect ratio, i.e. a ratio of its overall length to its greatest diameter anywhere along its length, of between 1 and 10, for example. Longer sensing electrodes and sensing electrodes having aspect ratios greater than 1 tend to result in a larger capacitance of the primary capacitor, which in turn can result in a greater precision in sensing the elevated voltage of the bushing conductor.

A shorter tubular sensing electrode may have an annular shape. Even a short tubular sensing electrode is considered tubular, for example where its aspect ratio is less than 1, such as an aspect ratio of 0,8 or 0,5 or 0,3.

Since the sensing electrode is arranged coaxially around the bushing conductor, its inner diameter (or, more generally, the radial extension of the cavity formed by the sensing electrode) is larger than the outer diameter of the bushing conductor, so that the sensing electrode can receive a section of the bushing conductor.

In a certain embodiment, the sensing electrode is a copper sheet bent into a cylindrical shape having a diameter of about 30 to 40 millimetres (mm) and a length of about 60 mm, with the radial distance between the bushing conductor and the sensing electrode being more than 4 mm, preferably more than 5 mm.

In order to reduce the risk of delamination of solidified casting material from the surface of the sensing electrode, the sensing electrode may comprise a mesh of conductive wires forming apertures between them. In certain embodiments the sensing electrode is a mesh of conductive wires forming apertures between them. During the molding process, liquid casting material can flow through the apertures into the cavity formed by the tubular sensing electrode. Liquid casting material will be present in the apertures, forming many "bridges" between casting material outside of the sensing electrode and casting material inside the sensing electrode. After solidification of the casting material, these "bridges" connect solidified casting material outside of the sensing electrode with solidified casting material inside the sensing electrode. The apertures of the mesh allow casting material outside the sensing electrode to be mechanically connected with casting material inside the sensing electrode during solidification of the casting material and thereafter. This connection keeps the casting material connected in the vicinity of the sensing electrode and thereby helps reduce the risk of delamination of the casting material, which would result in the formation of voids. Presence of voids, in turn, increases the risk of electrical discharges within the casting material and resulting failures of the electrical insulation provided by the casting material.

In certain embodiments, the plurality of apertures comprises at least one hundred apertures or at least one thousand apertures or at least ten thousand apertures. Depending on the choice of viscosity of the casting material and the size of the apertures, one hundred apertures is deemed to be a typical minimum number of apertures for ensuring adequate contact between casting material radially outside the sensing electrode and casting material radially inside the sensing electrode. In certain other embodiments, however, the plurality of apertures comprises ten or more apertures, or fifty or more apertures.

In balancing these requirements, a few tens, or a few hundreds or a few thousands of apertures may be a desirable choice for sensored bushings according to this disclosure in which the sensing electrode has, for example, a length of between 30 mm and 60 mm and an inner diameter of between 30 mm and 50 mm.

The apertures may generally be positioned randomly in the sensing electrode. However, in order to provide for a good coherence between portions of the casting material outside the sensing electrode and portions of the casting material inside the sensing electrode in all parts of the sensing electrode, in certain preferred embodiments the apertures between the conductive wires of the mesh are evenly distributed over the mesh of conductive wires of the sensing electrode. An even distribution relates to approximately the same number of apertures per unit area of the sensing electrode. Preferably the apertures form a regular, repetitive pattern of identically-sized apertures. Preferably they form a regular, repetitive pattern of identically-sized and identically-spaced apertures. Identically-spaced apertures help obtain a greater accuracy of the capacitance of the primary capacitor and hence of the voltage measurement.

Alternatively, the sensing electrode may comprise a conductive sheet having apertures or through-holes therein, the apertures or through-holes allowing casting material outside the sensing electrode to be mechanically connected with casting material inside the sensing electrode during solidification of the casting material and thereafter.

In either configuration (mesh or sheet), the apertures or through-holes may extend in a thickness direction of the sensing electrode, i.e. in radial directions. The size of the apertures may be, for example, between 0,01 square millimetres (mm²) and 5 square millimetres. These sizes provide for a good coherence of the casting material through the sensing electrode while ensuring a sufficiently even distribution of the electrical field.

The shield electrode of a bushing according to the present disclosure is tubular. The shield electrode may have, for example, a cylindrical shape, i.e. the shape of the curved surface of a cylinder. The tubular shield electrode may have, for example, a circular cross section or an elliptical cross section or a rectangular or square cross section. The tubular shield electrode may have an aspect ratio, i.e. a ratio of its overall length to its greatest diameter anywhere along its length, of between 1 and 10. Longer shield electrodes and shield electrodes having aspect ratios greater than 1 tend to result in a more effective shielding of the sensing electrode, which in turn can result in a greater precision in sensing the elevated voltage of the bushing conductor.

A shorter tubular shield electrode may have an annular shape. Even a short tubular shield electrode is considered tubular, for example where its aspect ratio is less than 1, such as an aspect ratio of 0,8 or 0,5 or 0,3.

Since the shield electrode is arranged coaxially around the sensing electrode, its inner diameter (or, more generally, the radial extension of the cavity formed by the shield electrode) is larger than the outer diameter of the sensing electrode, so that the shield electrode can receive the sensing electrode or at least a section of the sensing electrode.

In a certain embodiment, the shield electrode is a copper sheet bent into a cylindrical shape having a diameter which is between about 5 mm and about 20 mm larger than the outer diameter of the sensing electrode. The radial distance between the sensing electrode and the shield electrode is thus between about 2,5 mm and about 10 mm. The shield electrode may have through-holes as described above for the sensing electrode. The shield electrode may be, or comprise, a mesh of conductive wires as described above for the sensing electrode.

A sensored bushing according to the present disclosure comprises a first spacer to maintain the sensing electrode and the shield electrode in a fixed spatial relation to each other during solidification of the casting material. In certain embodiments the sensored bushing further comprises a second spacer, embedded in the casting material and arranged radially between the sensing electrode and the shield electrode, wherein the second spacer is mechanically connected to the sensing electrode and to the shield electrode to maintain the sensing electrode and the shield electrode in a fixed spatial relation to each other.

The second spacer may be arranged coaxially with the first spacer. It may be arranged axially displaced from the first spacer. Where the first spacer comprises a flat major surface and the second spacer comprises a flat major surface, the first and the second spacer may be arranged such that their respective flat major surfaces are parallel to each other.

A second spacer may improve the mechanical stability of the electrode assembly further and maintain the electrodes in a fixed spatial relation to each other more reliably than the first spacer alone, thus potentially allowing for stronger flow of casting material into the mold, for example. The second spacer may be very similar to the first spacer. The description of the features of the (first) spacer therefore applies to the second spacer -and any further spacers - alike.

The spacer (i.e., the first spacer or the second spacer or both) may be of an annular shape. Its annular shape defines an inner perimeter and an outer perimeter of the spacer. A spacer of an annular shape may comprise a major surface which is delimited in radial directions by an outer perimetral edge (i.e. an edge at its outer perimeter) and an inner perimetral edge (i.e. an edge at its inner perimeter).

The inner perimetral edge may be mechanically connected to the sensing electrode, such as by soldering or by an adhesive, such as an electrically conductive adhesive or an electrically insulating adhesive. The inner perimetral edge may be mechanically connected to the sensing electrode in a plurality of discrete positions along the inner perimetral edge, such as two or three or four solder points, or such as two or three or four glue points. The discrete positions may be spaced, for example, at 90° angles with respect to each other.

Alternatively, the inner perimetral edge may be mechanically connected to the sensing electrode along the entire inner perimetral edge, i.e. for a full 360° angle of the perimeter. Such a full-perimeter connection may comprise, for example, a continuous solder line or a continuous line of adhesive along the entire inner perimetral edge.

Independent of any mechanical connection of the inner perimetral edge, the outer perimetral edge of an annular-shaped spacer may be mechanically connected to the shield electrode, e.g. by soldering or by an adhesive, such as an electrically conductive adhesive or an electrically insulating adhesive. The outer perimetral edge may be mechanically connected to the shield electrode in a plurality of discrete positions along the outer perimetral edge, such as two or three or four solder points, or such as two or three or four glue points, spaced at 90° angles with respect to each other.

Alternatively, the outer perimetral edge may be mechanically connected to the shield electrode along the entire outer perimetral edge, i.e. for a full 360° angle of the perimeter. Such a full-perimeter connection may comprise, for example, a continuous solder line or a continuous line of adhesive along the entire outer perimetral edge.

Hence in certain embodiments of the sensored bushing, the first spacer is of annular shape and comprises a flat major surface delimited radially by an outer perimetral edge and an inner perimetral edge, wherein the first spacer is mechanically connected to the sensing electrode at the inner perimetral edge, and wherein the first spacer is mechanically connected to the shield electrode at the outer perimetral edge.

Where an annular spacer is connected mechanically to the sensing electrode at an inner perimetral edge, the same inner perimetral edge may also be useful in establishing an electrical connection of electrical components arranged on the spacer to the sensing electrode. An electrical connection via the inner perimetral edge may make a separate electrical connection between such components and the sensing electrode obsolete and thereby make the design of the sensored bushing simpler. In particular, where a low-voltage capacitor of the sensing voltage divider is mounted on the spacer, it can be electrically connected to the primary capacitor via the inner perimetral edge.

Hence independent of any mechanical connections, in certain embodiments the first spacer comprises, on the major surface, a first conductive trace and a second conductive trace for respective electrical connection of electric or electronic components mounted on the first spacer, and the inner perimetral edge comprises a conductive portion, said conductive portion being conductively connected with the first conductive trace and conductively connected with the sensing electrode. Optionally also the outer perimetral edge comprises a conductive portion, said conductive portion being conductively connected with the second conductive trace and conductively connected with the shield electrode.

Independent of the inner perimetral edge, in certain embodiments the spacer comprises, on the major surface, a second conductive trace for respective electrical connection of electric or electronic components mounted on the spacer, and the outer perimetral edge comprises a conductive portion, said conductive portion being conductively connected with the second conductive trace and conductively connected with the shield electrode.

In certain embodiments the spacer is, or comprises, a printed circuit board ("PCB"). In certain of these embodiments the sensing electrode is mechanically connected to the PCB and is electrically connected to a conductive trace on the PCB and to further electrical components, e.g. to an electrode of a low-voltage capacitor of a sensing voltage divider such that the primary capacitor and the low-voltage capacitor form a sensing voltage divider for sensing the elevated voltage of the bushing conductor. For facilitating electrical connection to the sensing electrode, a portion of the inner perimeter of an annular PCB spacer may be electrically conductive. The sensing electrode may be electrically connected to a conductive trace or to an electric component mounted on the PCB via the conductive portion of the inner perimeter.

In certain embodiments the shield electrode is mechanically connected to the PCB and is electrically connected to a conductive trace on the PCB and to further electrical components, e.g. to a grounding point on the PCB. For facilitating electrical connection to the shield electrode, a portion of the outer perimeter of an annular PCB spacer may be electrically conductive. In such embodiments the shield electrode may be electrically connected to a conductive trace or to an electric component mounted on the PCB via the conductive portion of the outer perimeter.

A thickness of an annular spacer, i.e. its extension in a direction along its central axis, is not critical, as long as the spacer can hold the electrodes in a fixed spatial relation before and during the molding. In certain embodiments the spacer has a thickness of between 0,1 mm and 5,0 mm.

In certain embodiments the first spacer is arranged coaxially with the sensing electrode and the shield electrode. Where two or more spacers are present, the second spacer and any further spacers, if present, may be arranged coaxially with the first spacer.

Where two or more spacers are present, the second spacer and any further spacer may comprise a flat major surface. Where a second spacer is present, the second spacer may be arranged radially between the sensing electrode and the shield electrode such that the surface normal of the flat major surface is oriented parallel to the central axis of the tubular sensing electrode or to the central axis of the tubular shield electrode. Where two or more spacers are present, the second spacer and any further spacer may comprise a flat major surface and may be oriented such that a normal on the major surface is oriented parallel to the bushing axis. According to the present invention the first spacer comprises a flat major surface and is oriented such that a normal on the major surface is oriented parallel to a central axis of the tubular sensing electrode or to a central axis of the tubular shield electrode.

In certain embodiments the spacer is flat and comprises a first major surface and a second major surface, opposed to, and parallel to the first major surface. The spacer may be arranged radially between the sensing electrode and the shield electrode such that the surface normal of the first major surface is oriented parallel to the central axis of the tubular sensing electrode or to the central axis of the tubular shield electrode. Where the second spacer comprises a flat major surface, the second spacer may be arranged such that its flat major surfaces is oriented parallel to the flat major surface of the first spacer.

The spacer may comprise, or be made of, a polymeric material. In certain embodiments, the spacer comprises, or is made of, an epoxy material, such as a glass-reinforced epoxy laminate, e.g. an FR4 material.

In certain embodiments the spacer is incompressible in axial direction, in radial direction or in both directions. In other embodiments the spacer is elastically deformable in axial directions, in radial directions or in both directions.

A desired fixed spatial relation between the sensing electrode and the shield electrode may be the coaxial arrangement of these electrodes and a specific axial position of the shield electrode relative to the sensing electrode. The spacer(s) may be suitable for maintaining the radial position of the sensing electrode relative to the shield electrode by filling a radial gap between these electrodes. The spacer(s) may be suitable for maintaining the axial position of the sensing electrode relative to the shield electrode by virtue of being mechanically connected to both electrodes.

During the manufacturing of a sensored bushing according to the present disclosure, liquid casting material is made to flow into all volumes of the mold such as to embed the electrode assembly completely in casting material. To facilitate flow in axial directions of casting material into the radial space between the sensing electrode and the shield electrode (i.e. into the "inter-electrode space") the spacer, and each spacer, may comprise one or more flow openings through which the liquid casting material can flow through the spacer in a thickness direction of the spacer into the inter-electrode space. Hence in certain embodiments the first spacer comprises one or more apertures for allowing liquid casting material to flow from one side of the first spacer through the one or more apertures to the opposite side of the first spacer.

In certain embodiments in which the sensored bushing comprises a first spacer and a second spacer, the first spacer and the second spacer each comprise one or more flow openings through which the liquid casting material can flow through the spacer in a thickness direction of the spacer into the inter-electrode space.

In certain embodiments the first spacer is, or comprises, a printed circuit board. In some of these embodiments the first spacer is, or comprises, a rigid printed circuit board. A rigid printed circuit board is flat and has a flat first major surface and an opposed parallel flat second major surface. A spacer being or comprising a PCB is referred to herein also as a "PCB spacer".

In certain embodiments in which the first spacer is, or comprises, a rigid PCB, the PCB is arranged radially between the sensing electrode and the shield electrode such that the surface normal of the first major surface is oriented parallel to the central axis of the tubular sensing electrode or to the central axis of the tubular shield electrode.

In certain of these embodiments the PCB spacer has an annular shape defining an inner perimeter and an outer perimeter. Such a PCB spacer is referred to herein also as an "annular PCB spacer". The inner perimeter may be mechanically connected to the sensing electrode, e.g. in the ways described above. The outer perimeter may be mechanically connected to the shield electrode, e.g. in the ways described above.

Electric and electronic components such as, for example, capacitors, resistors, or inductors, may be mounted on the PCB. The PCB may comprise conductive traces for electrical connection between electric and electronic components mounted on the PCB or connected to the PCB.

In certain embodiments a low-voltage capacitor of the sensing voltage divider for sensing the voltage of the bushing conductor is mounted on the PCB spacer. Mounting the low-voltage capacitor on the PCB spacer is advantageous because it facilitates short electrical paths between the sensing electrode and the low-voltage capacitor, reducing the risks of picking up electromagnetic noise and of imperfect electrical connections, and avoiding the necessity for an external PCB outside the bushing for mounting the low-voltage capacitor thereon. Mounting the low-voltage capacitor on the PCB spacer generally provides reliable mechanical support for the low-voltage capacitor and facilitates electrical connection of the low-voltage capacitor to other electric elements inside or outside of the bushing.

Hence generally in certain embodiments of a sensored bushing according to the present disclosure the first spacer is, or comprises, a printed circuit board, and the bushing further comprises a low-voltage capacitor conductively connected with the sensing electrode and mounted on the printed circuit board, wherein the low-voltage capacitor is comprised in a low-voltage portion of the sensing voltage divider for sensing the elevated voltage of the bushing conductor, and wherein the primary capacitor is comprised in a high-voltage portion of the sensing voltage divider.

Having both the high-voltage portion (i.e. the primary capacitor) and the low-voltage portion (i.e. the low-voltage capacitor) of the sensing voltage divider be comprised in the sensored bushing is advantageous in that the dividing ratio of the sensing voltage divider can be set in the factory, making later calibration work during installation obsolete. This may help in obtaining a higher degree of precision in the voltage sensing. Also, the arrangement of both capacitors in the sensored bushing prevents tampering or errors in the calibration process. Arrangement of the low-voltage capacitor on a PCB facilitates electrical connections of other electrical components to the low-voltage capacitor. Also an arrangement of the low-voltage capacitor on a PCB is advantageous in that a low-voltage capacitor of a certain capacitance can more easily be replaced with a low-voltage capacitor of a different capacitance. Facilitating such a replacement may be desirable to customize the sensored bushing towards specific dividing ratios of the sensing voltage divider that may be required by a specific customer application.

The low-voltage capacitor may have a capacitance of between 10 and 1000 nanofarad (nF). Where the elevated voltage is about 20 kV or 30 kV, the low-voltage capacitor may have a capacitance of between 100 and 500 nF, for example.

The low-voltage capacitor mounted on the PCB spacer is electrically connected with the sensing electrode. The low-voltage capacitor mounted on the PCB spacer is electrically connected in series with the primary capacitor. The low-voltage capacitor mounted on the PCB spacer may be electrically connected between the sensing electrode and electrical ground. The low-voltage capacitor mounted on the PCB spacer may be electrically connected to ground via one or more further low-voltage capacitors.

The low-voltage capacitor is comprised in the sensing voltage divider for sensing the elevated voltage of the bushing conductor. Said sensing voltage divider further comprises the primary capacitor formed by the bushing conductor and the sensing electrode. This primary capacitor is serially connected between the low-voltage capacitor and the elevated voltage of the bushing conductor. The primary capacitor comprises as its electrodes the bushing conductor and the sensing electrode, and as its dielectric a portion of the casting material. The primary capacitor is thus an integrated capacitor.

An integrated capacitor, as used herein, is a capacitor that is formed by structural elements of the bushing, as opposed to a discrete capacitor which is a separate, individual capacitor that exists independently from structural elements of the bushing. A surface-mount capacitor is an example of a discrete capacitor.

In certain embodiments a bushing according to the present disclosure comprises one low-voltage capacitor, or a plurality of low-voltage capacitors. A low-voltage capacitor may be a discrete capacitor or an integrated capacitor. Sensored bushings comprising a discrete low-voltage capacitor, such as a surface-mounted low-voltage capacitor, may be more easily adaptable to a desired dividing ratio or to a desired signal voltage than sensored bushings comprising an integrated low-voltage capacitor whose capacitance is not easy to change, because during assembly, a discrete low voltage capacitor of a suitable capacitance can be chosen.

The high-voltage electrode of the primary capacitor of the sensing voltage divider is the bushing conductor on the elevated voltage, while the low-voltage electrode is the sensing electrode which is generally on a considerably lower voltage, so that parasitic currents flow through the casting material between these electrodes. These parasitic currents can be described by "parasitic capacitances". In typical sensored bushings for elevated voltages of about 50 kV, these parasitic capacitances are typically between 1 and 10 pF (picofarad), varying generally with the temperature of the casting material. For precise voltage measurement, the capacitance of the primary capacitor - or generally of the high-voltage portion of the sensing voltage divider - should be clearly greater than these 1-10 pF, so that the signal voltage is not influenced greatly by variations of the parasitic capacitances. A capacitance of the primary capacitor which is larger than 10 pF is therefore desirable. Also, the sensing voltage divider is usually connected to a voltage measurement device which senses the divided voltage (the signal voltage) and determines the elevated voltage from the divided voltage. A higher capacitance of the primary capacitor is desirable in order to reduce the influence of the input impedance of the voltage measurement device and to thereby provide for a higher accuracy in sensing the elevated voltage.

The casting material is an electrically insulating material. It is flowable, i.e. liquid or viscous, when manufacturing the bushing body from the casting material, so that during a casting process the casting material can flow, e.g. through apertures of the mesh of conductive wires of the sensing electrode, into the space between the sensing electrode and the bushing conductor.

After molding the casting material can be solidified, i.e. hardened. Its solidification results in a hard and rigid casting material and consequently in a rigid body of the bushing. The casting material may solidify, for example, by curing. Curing may be effected by drying at room temperature or in an oven, or it may be effected by exposing the casting material to radiation, such as ultraviolet radiation or electron beam radiation. The casting material may contain a curing agent.

In certain embodiments the casting material is flowable at temperatures of 20°C or more. Such casting materials may, for example, solidify by evaporation of certain of its constituents or it may solidify, for example, by a forced curing process, such as UV curing or electron beam curing. In certain other embodiments the casting material may be flowable at temperatures of 80°C or more, or 100°C or more. Such casting materials may, for example, solidify by cooling to a lower temperature, e. g. to temperatures of 30°C or lower.

The casting material may be, or may comprise, an epoxy resin or a polyurethane resin. The casting material may be a mixture of one or more resin materials with one or more filler materials. A filler material may be, for example, SiO₂ or Al₂O₃ or a ceramic material.

Before it solidifies, the casting material is in a liquid or viscous state, so that it can flow into the inter-electrode space and into the space between the sensing electrode and the bushing conductor within a time frame that is reasonable for an industrial production process, e. g. within a few seconds up to a minute or several minutes. A viscosity of a casting material may depend on its temperature. For an industrial production process, it is advisable to select a casting material that has a sufficiently low viscosity to be flowable at an operating temperature of the casting process. An operating temperature of a suitable casting process for casting the bushing body may be, for example, about 25°C or about 50°C or about 100°C or about 130°C. Casting materials for these operating temperature ranges are readily available. Viscosities below about 20'000 mPa.s at 20°C appear generally suitable for the casting material during an industrial casting process, independent of the method used for measuring the viscosity.

A portion of the casting material forms the dielectric of the primary capacitor. The electrical properties of the casting material will be affected by its temperature, which may rise, for example, when strong currents flow through the bushing conductor and heat up the bushing conductor. The rise in its temperature will also lead to some mechanical expansion of the casting material, resulting in a larger gap between the sensing electrode and the bushing conductor. At least these effects will thus change the capacitance of the primary capacitor and thereby also change the dividing ratio of the sensing voltage divider in an uncontrolled manner. Since the magnitude of the elevated voltage is obtained by multiplying the signal voltage with the dividing ratio, an uncontrolled variation of the dividing ratio will render the magnitude of the elevated voltage less precise.

Instead of attempting to avoid temperature variations of the capacitance of the primary capacitor, e.g. by selecting a casting material with a low coefficient of thermal expansion, it is contemplated herein to compensate for those variations. For that purpose the sensored bushing according to the present disclosure may be equipped with a temperature-dependent resistor, such as a thermistor or a Pt100 Platinum-based temperature-dependent resistor, whose resistance depends considerably and intentionally on its temperature. Preferably it is arranged in the bushing body and is thermally coupled or thermally connected to the casting material. Certain temperature-dependent resistors have a relative resistance temperature dependency of ΔR/R₀ of greater than 1 x 10⁻³ per degree Celsius and may thereby be useable as such a "correction resistor", where ΔR is the change in resistance between 0°C and 100°C, and R₀ is the resistance at 0°C. Preferably the temperature-dependent resistor is a PTC ("positive temperature coefficient") resistor, the electrical resistance of which increases with increasing temperature.

To perform a temperature correction of the signal voltage, the signal voltage may, for example, be electrically connected to a first input of an operational amplifier (OpAmp), and the correction resistor may be connected between a second input of the OpAmp and electrical ground. The correction resistor thereby provides an electrical correction signal which varies with the temperature of the casting material. The amplification of the signal voltage by the OpAmp is modified by the correction signal such that the impact of a temperature drift of the dividing ratio of the sensing capacitor is reduced. This results in a more precise sensing of the elevated voltage.

The OpAmp is preferably arranged in a separate processing unit, such as an RTU, outside the sensored bushing. A correction contact, accessible from outside the bushing, can help facilitate electrical connection of the processing unit to the correction resistor.

Hence generally, and independent from other features of the sensored bushing described herein, in certain embodiments the sensored bushing further comprises
a) a correction contact, accessible from outside the sensored bushing; and
b) a correction resistor having a temperature-dependent electrical resistance for providing, at the correction contact, a correction signal which varies with a temperature of the casting material, wherein the correction resistor
   - is arranged in the bushing body;
   - is thermally connected to the casting material; and
   - is electrically connected to the correction contact.

The correction resistor may have a relative resistance temperature dependency of ΔR/R₀ > 1 x 10⁻⁴ per degree Celsius, where ΔR is the change in resistance between 0°C and 100°C, and R₀ is the resistance at 0°C. The correction resistor may have a relative resistance temperature dependency of ΔR/R₀ > 1 x 10⁻³ per degree Celsius. The correction resistor may be a thermistor. The correction resistor may be a PT100 resistor.

In certain embodiments the correction resistor is arranged on the first spacer. This arrangement facilitates reliable electrical connection of the correction resistor to other electrical components and ensures reliable support of the correction resistor. This arrangement provides the additional benefit of the correction resistor being arranged in the bushing body and close to the primary capacitor, thus allowing the correction resistor to pick up the temperature of the bushing body in the vicinity of the primary capacitor. This is, in turn, advantageous because the correction signal is used to compensate temperature-related variations of the capacitance of the primary capacitor, originating from the increase of the dielectric number εᵣ of the dielectric of the primary capacitor with increasing temperature.

The sensing electrode, the shield electrode and the bushing conductor of the bushing according to the present disclosure are embedded in the casting material forming the bushing body. As used herein, an element is "embedded" in a material if it is surrounded on all sides by that material. An embedded element may be in surface contact with the material, or it may not be in contact with the material.

A portion of the sensing electrode may be in surface contact with a portion of the solidified casting material. A portion of the bushing conductor may be in surface contact with a portion of the solidified casting material. A portion of the shield electrode may be in surface contact with a portion of the solidified casting material.

In certain embodiments the sensored bushing according to this disclosure further comprises a signal contact, conductively connected to the sensing electrode and arranged on an outer surface of the bushing body. The sensored bushing optionally further comprises a grounding contact, conductively connected to the shield electrode and arranged on an outer surface of the bushing body.

The signal contact allows accessing the signal voltage of the sensing voltage divider outside the bushing. The signal voltage can be led, e.g by a shielded wire, to an external processing unit such as an RTU. In such a processing unit the signal voltage may, for example, be digitized. It may then be multiplied with the value of the dividing ratio of the sensing voltage divider and thereby yield the magnitude of the elevated voltage. An arrangement of the signal contact on an outer surface of the bushing facilitates electrical connection to the signal contact. The signal contact may have, for example, the form of a connector or of a soldering point.

Similarly, the grounding contact allows connection of the sensing voltage divider to electrical ground outside the bushing. The grounding contact can be connected, e.g by a shielded wire, with electrical ground of an external processing unit such as an RTU. An arrangement of the grounding contact on an outer surface of the bushing facilitates electrical connection to external ground. The grounding contact may have, for example, the form of a connector or of a soldering point.

An electrical apparatus, such as a switchgear or a transformer, in a power distribution network for distributing electrical power at medium or high voltages may be easily provided with voltage sensing capabilities by comprising a sensored bushing according to the present disclosure without having to make major changes to the other elements of the apparatus. This may make retrofitting of voltage sensors to an apparatus particularly easy and cost-effective. The present disclosure therefore also provides an electrical apparatus, such as a switchgear or a transformer, in a power distribution network of a national grid for distributing electrical power at medium or high voltages, the apparatus comprising
a) a power conductor, such as a bus bar or a central conductor of a power cable, in the apparatus for conducting the electrical power at currents of ten Ampère or more, and
b) a sensored bushing as described herein, wherein the power conductor is electrically connected to the bushing conductor.

Along the same lines, an entire MV/HV power distribution network may be easily upgraded to a network having voltage sensing capabilities by integrating an apparatus with a sensored bushing as described herein into the network. The present disclosure therefore also provides a power distribution network of a national grid for distributing electrical power at medium or high voltages, the network comprising an apparatus as described above.

There is a need for a faster and simpler molding process of sensored bushings that requires less assembly time and fewer parts, while maintaining a spatial relationship between the shield electrode and the sensing electrode during the molding process and thereafter. In attempt to address these needs the present disclosure also provides a process of manufacturing a sensored bushing for connecting a separable connector to a switchgear or to a transformer in a power distribution network of a national grid for distributing electrical power at medium or high voltages, the sensored bushing comprising
a) a bushing body;
b) an elongated bushing conductor, embedded in the bushing body, for conducting power at currents of ten Ampère or more, the length direction of the bushing conductor defining axial directions and radial directions orthogonal to the axial directions; and
c) an electrode assembly embedded in the bushing body, arranged coaxially around the bushing conductor and comprising
   i) a tubular sensing electrode,
   ii) a tubular shield electrode, arranged coaxially around the sensing electrode,
   iii) a first spacer, arranged radially between the sensing electrode and the shield electrode, and mechanically connected to the sensing electrode and to the shield electrode to maintain the sensing electrode and the shield electrode in a fixed spatial relation to each other wherein the first spacer comprises a flat major surface and is oriented such that a normal on the major surface is oriented parallel to a central axis of the tubular sensing electrode or to a central axis of the tubular shield electrode;
   wherein the process comprises
   - arranging the electrode assembly such that the sensing electrode is arranged coaxially around the bushing conductor, and - previously or subsequently

   - arranging the bushing conductor and the electrode assembly in a mold;
      - filling the mold with a liquid, electrically insulating, solidifiable casting material such that the bushing conductor and the electrode assembly are embedded in the casting material and such that portions of the casting material are arranged between the bushing conductor and the sensing electrode and between the sensing electrode and the shield electrode;
      - solidifying the casting material to form the bushing body such that the bushing conductor and the electrode assembly are embedded in the casting material

In a process in which an electrode assembly with a sensing electrode and a coaxial shield electrode are arranged coaxially around the bushing conductor in a mold to be filled with a liquid casting material, the spacer helps to establish and maintain a spatial relation between the electrodes, so that a single electrode assembly is arranged in a single step in the mold instead of separate electrode being placed consecutively, and so that the sensing electrode and the shield electrode cannot be displaced easily with respect to each other in the molding process or thereafter.

Due to the first spacer, the bushing is easier to manufacture at a high geometric precision level of the desired spatial relation between the shield electrode and the sensing electrode. This is because the first spacer helps, during the molding process, to maintain the shield electrode and the sensing electrode in a fixed spatial relation relative to each other, so that after the molding and after solidification the geometry of the electrodes is closer to the desired geometry. This applies both to the shape of the individual electrodes and to their relative position and relative orientation. The resulting bushing is of a greater geometric precision with respect to the spatial relation between sensing electrode and shield electrode and can thus sense the elevated voltage at a greater precision.

The invention will now be described in more detail with reference to the following Figures exemplifying particular embodiments of the invention:
- Fig. 1: Sectional view of a separable connector and a first sensored bushing according to the present disclosure;
- Fig. 2: Circuit diagram of a sensing voltage divider comprising the primary capacitor of a sensored bushing according to the present disclosure;
- Fig. 3: Sectional view of the first sensored bushing; and
- Fig. 4: Perspective sketch of an electrode assembly of a second sensored bushing according to the present disclosure.

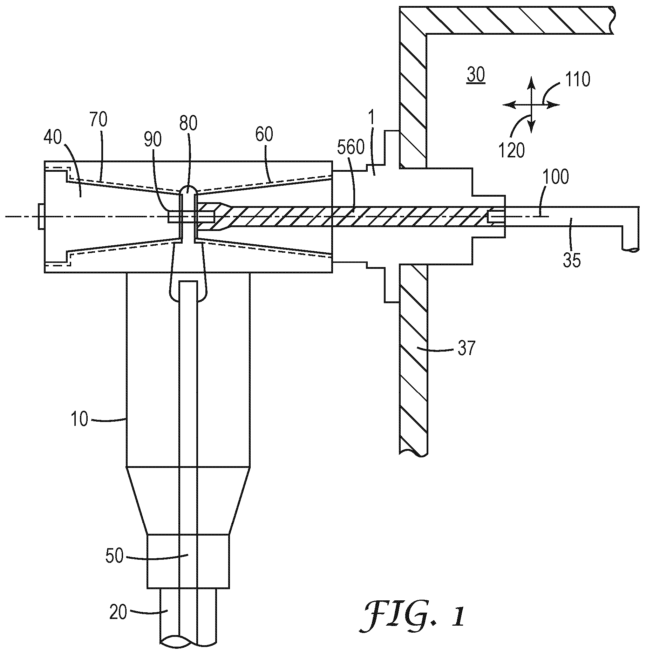

The sectional view of **Figure 1** illustrates a separable connector 10 and a first sensored bushing 1 according to the present disclosure. The separable connector 10 is arranged at an end of a medium-voltage power cable 20 and connects, via the bushing 1, the power-carrying central conductor 50 of the cable 20 to a medium-voltage switchgear 30 in a power distribution network of a national grid.

The separable connector 10 is a T-shaped separable connector 10 and comprises a front cavity 60 for receiving a portion of the bushing 1, and a rear cavity 70 for receiving an insulation plug 40 of a matching shape. The insulation plug 40 serves to electrically insulate a connection element 80 of the separable connector 10, which is electrically connected to the central conductor 50 of the cable 20 and can be electrically and mechanically connected to a bushing conductor 560 in the bushing 1 via a threaded stud 90. In use, the connection element 80 is on the elevated voltage of the central conductor 50 of the cable 20.

Bushings in general are components that lead power at high or medium voltages to a current conductor 35 in a network apparatus (e.g. of a switchgear 30 or of a transformer) through an opening in an outer wall 37 of the apparatus. For that purpose, a bushing comprises an elongated conductor ("bushing conductor") for conducting the power on elevated voltage, and an insulating body surrounding the bushing conductor.

The sensored bushing 1 according to the present disclosure, just like a traditional bushing, has an overall frusto-conical protrusion and is generally rotationally symmetric about a bushing axis 100 which defines axial directions 110 and radial directions 120, which are directions orthogonal to the axial directions 110. The separable connector 10 can be engaged with the bushing 1 by moving it axially in an axial direction 110 towards and over the frustoconical protruding portion of the bushing 1 and by threading the conductive stud 90 into a threaded bore in the bushing conductor 560. Thereby the bushing conductor 560 is electrically connected - via the connection element 80 - with the central conductor 50 of the cable 20 on elevated voltage. In the illustrated embodiment the geometry of the sensored bushing 1 is adapted to conform to ANSI/IEEE standard 386.

The sensored bushing 1 comprises an integrated primary capacitor, which can be electrically connected, via the bushing conductor 560, to the connection element 80 on elevated voltage and which is operable as a high-voltage capacitor in a sensing voltage divider for sensing the elevated voltage, as will be explained in the context of the other Figures.

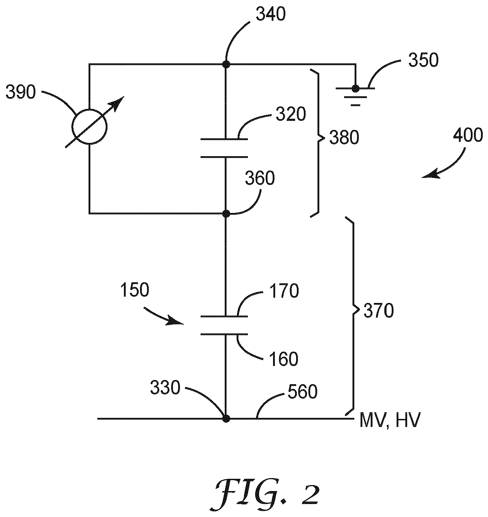

**Figure 2** is a circuit diagram of a sensing voltage divider 400 for sensing the elevated voltage of the bushing conductor 560 of the bushing 1 of the present disclosure.

The sensing voltage divider 400 for sensing the elevated voltage of the bushing conductor 560 is shown electrically connected to the bushing conductor 560 on medium or high (i.e. elevated) voltage at a high-voltage contact 330. The voltage divider 400 comprises a high-voltage capacitor 150, corresponding to the primary capacitor 150 in the sensored bushing 1 described below, and a low-voltage capacitor 320. These two capacitors 150, 320 are electrically connected in series between the elevated voltage of the bushing conductor 560 and a grounding contact 340, held on electrical ground 350. The grounding contact 340 facilitates connection of the sensing voltage divider 400 to electrical ground 350.

A signal contact 360 is arranged electrically between a high-voltage portion 370 and a low-voltage portion 380 of the sensing voltage divider 400. At the signal contact 360, a divided voltage, also referred to herein as the signal voltage, can be picked up, which varies proportionally with the elevated voltage of the bushing conductor 560. The dividing ratio, i.e. the proportionality factor between the elevated voltage and the signal voltage, depends on the ratio of the total impedance of the high-voltage portion 370 to the total impedance of the low-voltage portion 380 of the voltage divider 400. By measuring the signal voltage of the signal contact 360 using a voltmeter 390 and applying the proportionality factor, the elevated voltage of the bushing conductor 560 can be sensed.

In the illustrated embodiment, the high-voltage portion 370 comprises only one capacitor, namely the primary capacitor 150, with its high-voltage electrode 160 and its low-voltage electrode 170. In other embodiments the high-voltage portion 370 may comprise, beyond the primary capacitor 150, one or more further capacitors or one or more further impedance elements, such as one or more resistors and/or one or more inductors.

Similarly, in the illustrated voltage divider 400, the low-voltage portion 380 comprises only one capacitor, namely the low-voltage capacitor 320. In other embodiments the low-voltage portion 380 may comprise, beyond the low-voltage capacitor 320, one or more further capacitors or one or more further impedance elements, such as one or more resistors and/or one or more inductors.

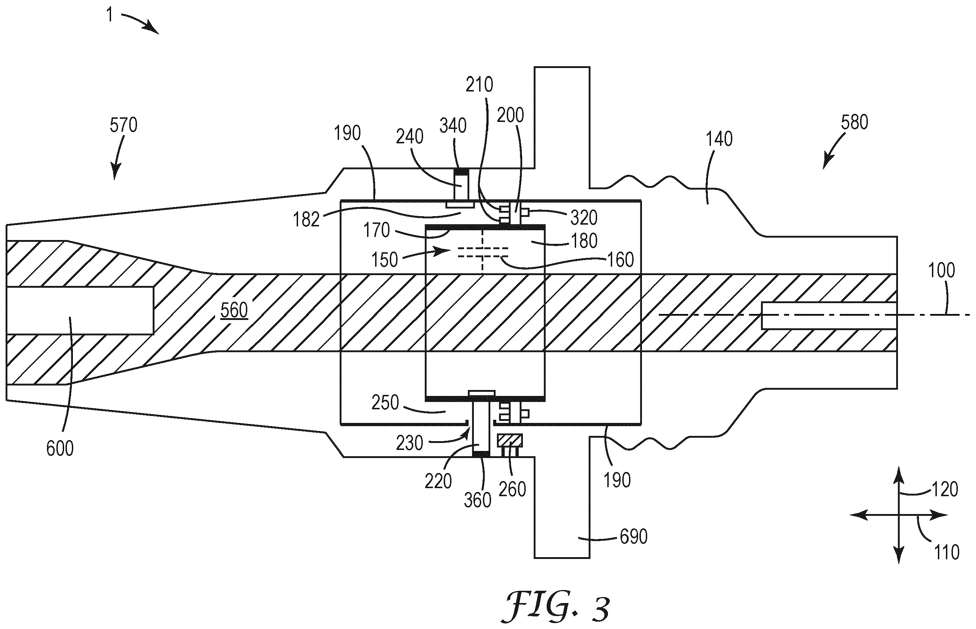

**Figure 3** is a sectional view of the first bushing 1 showing more details, like, for example, the primary capacitor 150 formed by the bushing conductor 560 and a sensing electrode 170, a shield electrode 190 and a spacer 200.

The sensored bushing 1 comprises an insulating bushing body 140 of an electrically insulating solidified casting material and surrounds the elongated bushing conductor 560 to electrically insulate the bushing conductor 560. The bushing 1 has a connector end portion 570 for electrical and mechanical connection to a separable connector 10, and an apparatus end portion 580 for electrical and mechanical connection to a current conductor 35 of the apparatus 30. The bushing 1 can be mounted in an opening of an outer wall 37 of the apparatus 30 at a flange 690. The connector end portion 570 has a frusto-conical shape to fit into a front cavity 60 of a separable connector 10 of corresponding shape. A threaded bore 600 in the bushing conductor 560 can engage with a threaded stud 90 as shown in Figure 1, so that the bushing conductor 560 is conductively connected, via the stud 90 and the connection element 80 of the separable connector 10, with the conductor 50 of the power cable 20.

The bushing body 140 and the bushing conductor 560 are generally rotationally symmetric about an axis 100. The axis 100 defines length directions or axial directions 110 of the bushing 1. Radial directions 120 are directions orthogonal to the axis 100.

A primary capacitor 150 is formed by a high-voltage electrode 160 (which is the bushing conductor 560) and a sensing electrode 170. The sensing electrode 170 is rotationally symmetric about the bushing axis 100 and has a generally tubular shape. The sensing electrode 170 is arranged concentrically with the bushing conductor 560 and surrounds the bushing conductor 560 completely, i.e. over a full 360° angle about the bushing axis 100. A dielectric of the primary capacitor 150 is formed by a first portion 180 of the casting material of the bushing body 140, located between the bushing conductor 560 and the sensing electrode 170.

The sensing electrode 170 comprises a mesh of conductive wires forming a plurality of apertures between the wires. The apertures allow the casting material radially outside the sensing electrode 170 to be mechanically connected with the casting material radially inside the sensing electrode 170 while the casting material solidifies and thereafter.

The sensing electrode 170 is completely surrounded by the casting material of the bushing body 140, in other words, it is embedded in the casting material. To facilitate external access to the voltage of the sensing electrode 170, a signal contact pin 220 is electrically connected to the sensing electrode 170 and extends through a second portion 182 of the casting material and through a corresponding opening 230 in the shield electrode 190 to a signal contact 360 on the outer surface of the bushing body 140. At the signal contact 360, the divided voltage or "signal voltage" of the sensing voltage divider 400 can be picked up which can be processed to determine a precise value of the elevated voltage of the bushing conductor 560.

The sensored bushing 1 further comprises the shield electrode 190 which has a tubular shape and is arranged coaxially around the sensing electrode 170. In axial directions 110, the shield electrode 190 is longer than the sensing electrode 170 and extends axially beyond the edges of the sensing electrode 170, thereby providing more effective shielding of the sensing electrode 170 against external electrical fields.

The shield electrode 190 is electrically insulated against the sensing electrode 170 by the second portion 182 of the casting material. This second portion 182 is arranged radially between the sensing electrode 170 and the shield electrode 190.

The shield electrode 190 is completely surrounded by the casting material of the bushing body 140, in other words it is embedded in the casting material. To facilitate external connection of the shield electrode 190 to ground, a shield contact pin 240 is electrically connected to the shield electrode 190 and extends through the casting material to a grounding contact 340 on the outer surface of the bushing body 140. At the grounding contact 340, the shield electrode 190 can be connected to external ground. The grounding contact 340 can also serve to provide external electrical ground to the sensing voltage divider 400, for example in certain embodiments in which both the primary capacitor 150 and a low-voltage capacitor 320 are comprised in the sensored bushing 1.

The radially-outer shield electrode 190 and the radially-inner sensing electrode 170 are mechanically connected with each other by a first spacer 200. The first spacer 200 is also embedded in the casting material and is arranged radially between the sensing electrode 170 and the shield electrode 190. It maintains the sensing electrode 170 and the shield electrode 190 in a fixed spatial relation relative to each other. It helps prevent the electrodes 170, 190 from being pushed into a non-coaxial arrangement relative to each other, or from shifting in an axial direction 110 relative to each other. This is particularly important during the casting process, but also thereafter.

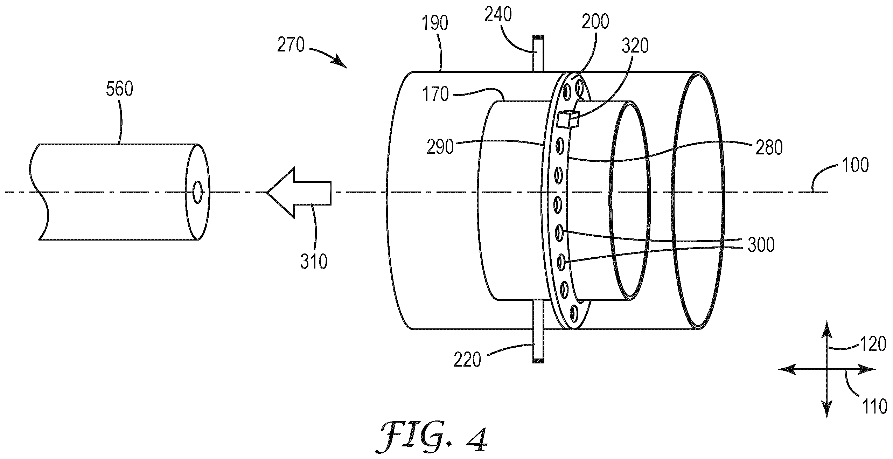

The first spacer 200 is a flat rigid circuit board 200 and is arranged coaxially with the sensing electrode 170 and the shield electrode 190, centered on the bushing axis 100. It has two parallel major surfaces on which electronic components 210 are arranged, connected with each other by conductive traces on the major surfaces of the circuit board 200. The spacer 200 has an annular shape (similar to the shape of a flattened donut) defining an inner perimetral edge and an outer perimetral edge, illustrated in greater detail in Figure 4. The inner perimetral edge is mechanically connected to the sensing electrode 170 in a couple of discrete positions along the inner perimetral edge by soldering. Similarly, the radially outer perimetral edge of the spacer 200 is mechanically connected to the shield electrode 190 in a couple of discrete positions along the outer perimetral edge by soldering.

The circuit board of the spacer 200 is made of an electrically insulating material, namely a glassfiber-reinforced epoxy laminate, known as an FR4 material which is often used for rigid printed circuit boards.

During the molding process to make the bushing body 140 and to embed the bushing conductor 560, the sensing electrode 170, the spacer 200, the shield electrode 190 and other elements of the sensored bushing 1, liquid casting material flows into the space 250 radially between the sensing electrode 170 and the shield electrode 190 and fills that "inter-electrode space" 250. It is generally desired that the inter-electrode space 250 be filled completely with the casting material, without it leaving any unfilled pockets or voids which would tend to increase a risk of detrimental electrical discharges in the bushing body 140. A more complete fill can be achieved by reducing obstacles in the flow path of the liquid casting material where possible. Therefore, to facilitate flow of liquid casting material into the inter-electrode space 250 during molding, the spacer 200 is provided with through-holes or apertures 300 (visible in Figure 4) in a thickness direction of the spacer 200.

The solidified casting material of the bushing body 140 is a hardened epoxy resin. In manufacturing, the resin in its liquid state is cast or molded around the bushing conductor 560, the sensing electrode 170, the first spacer 200 and the shield electrode 190 in a mold that determines the outer shape of the bushing 1. The resin is then cured or hardened to solidify, resulting in a solid insulating bushing body 140 in which the shield electrode 190, the spacer 200, the sensing electrode 170 and the bushing conductor 560 are embedded. The electrical breakdown strength of the casting material is high enough to reliably prevent electric discharges between the bushing conductor 560 on elevated voltage and the sensing electrode 170.

The primary capacitor 150 of the sensored bushing 1 forms the high-voltage portion 370 of a sensing voltage divider 400 as illustrated in Figure 2. A low-voltage capacitor 320 forming the low-voltage portion 380 of this sensing voltage divider 400 is arranged in the bushing body 140, it is mounted on the spacer 200. The spacer 200 is thus operated as a substrate for supporting the low-voltage capacitor 320. By selecting a low-voltage capacitor 320 of a suitable capacitance, the dividing ratio of the sensing voltage divider 400 can be set close to a desired value.

The low-voltage capacitor 320 is a discrete surface-mount capacitor, electrically arranged in series between the primary capacitor 150 and electrical ground 350. One of its electrodes is conductively connected with the sensing electrode 170. The other one of its electrodes is connected with the grounding contact 340.

A variation in temperature of the sensored bushing 1 changes the electrical properties, such as the permittivity, of the casting material and also of the first portion 180 of the casting material forming the dielectric of the primary capacitor 150, resulting in a change of the capacitance of the primary capacitor 150 and in a corresponding change of the dividing ratio of the sensing voltage divider 400. A temperature variation will also affect the geometry of the primary capacitor 150 formed by the sensing electrode 170 and the bushing conductor 560, also resulting in a change of the capacitance of the primary capacitor 150 and in a change of the dividing ratio of the sensing voltage divider 400. A drift in the dividing ratio results in a reduced precision of the voltage sensing.

Instead of trying to avoid the temperature drift of the dividing ratio, e.g. by selecting materials with smaller coefficients of thermal expansion, the sensored bushing 1 described here comprises a correction resistor 260 which has a temperature-dependent electrical resistance, such as commercially available thermistors, e.g. PT100 thermistors. The correction resistor 260 is arranged in the bushing body 140 such that it is in thermal contact with the casting material. This thermal contact ensures that the correction resistor 260 is on approximately the same temperature as the bushing body 140. Ideally the correction resistor 260 is arranged close to the sensing electrode 170, thereby having a temperature close to the temperature of the sensing electrode 170 and of the dielectric of the primary capacitor 150. To avoid cluttering the Figure, electrical connections of the correction resistor 260 are not shown in Figure 3.

To perform a temperature correction of the signal voltage, the signal contact 360 may, for example, be electrically connected to a first input of an operational amplifier, and the correction resistor 260 may be connected between a second input of the operational amplifier and electrical ground. The correction resistor 260 thereby provides an electrical correction signal which varies with the temperature of the casting material. The amplification of the signal voltage is modified by the correction signal such that the impact of a temperature drift of the dividing ratio of the sensing capacitor 400 is reduced. This results in a more precise sensing of the elevated voltage.

**Figure 4** is a sketched perspective view of an electrode assembly 270 of the first sensored bushing 1.

The electrode assembly 270 comprises the tubular sensing electrode 170 and the tubular shield electrode 190, arranged coaxially around the sensing electrode 170, and the annular first spacer 200 with its inner perimetral edge 280 and its outer perimetral edge 290. For clarity, the shield electrode 190 is shown as if it were transparent, although in reality it may not be transparent.

The sensing electrode 170 is mechanically connected to the inner perimetral edge 280 of the spacer 200, while the shield electrode 190 is mechanically connected to the outer perimetral edge 290 of the spacer 200. The spacer 200 can thus maintain the electrodes 170, 190 in a fixed spatial relation relative to each other. In the perspective view of Figure 4, the apertures 300 in the first spacer 200 are visible, they have a diameter of about 1 millimeter. The apertures 300 allow liquid casting material to flow from one side of the first spacer 200 through the apertures 300 to the opposite side of the first spacer 200 during the molding process.

The low-voltage capacitor 320 is shown arranged on a major surface of the spacer 200, other electronic components 210 are not shown. The shield contact pin 240 and the signal contact pin 220 protrude radially from the electrode assembly 270.

When manufacturing the sensored bushing 1, the electrode assembly 270 is arranged coaxially around the bushing conductor 560, such that the sensing electrode 170 is arranged coaxially around the bushing conductor 560. This can be done, for example, by pushing the electrode assembly 270 in an axial direction 110 over the bushing conductor 560, as indicated by arrow 310.

Before or after this step of arranging the electrode assembly 270 around the bushing conductor 560, the bushing conductor 560 and the electrode assembly 270 are arranged in a mold. Preferably they are arranged in the mold such that they are arranged coaxially with the bushing axis 100. The mold is then filled with a liquid, electrically insulating, solidifiable casting material such that the bushing conductor 560 and the electrode assembly 270 are embedded in the casting material and such that portions of the casting material are arranged between the bushing conductor 560 and the sensing electrode 170 and between the sensing electrode 170 and the shield electrode 190. The casting material is then solidified, e.g. by an active or passive curing process, to form the bushing body 140 such that the bushing conductor 560 and the electrode assembly 270 are embedded in the casting material.

## Claims

1. Sensored bushing (1) for connecting a separable connector (10) to a switchgear (30) or to a transformer in a power distribution network of a national grid for distributing electrical power at medium or high voltages, the bushing (1) comprising
a) a bushing body (140) comprising a solidified, electrically insulating casting material;
b) an elongated bushing conductor (560), embedded in the casting material, for conducting power at an elevated voltage and at currents of ten Ampère or more into the switchgear (30) or the transformer, the length direction of the bushing conductor (560) defining a bushing axis (100) and axial directions (110) and radial directions (120) orthogonal to the bushing axis (100);
c) a tubular sensing electrode (170), embedded in the casting material and arranged coaxially around the bushing conductor (560),
wherein the sensing electrode (170) and the bushing conductor (560) are operable as electrodes of a primary capacitor (150), a dielectric of the primary capacitor (150) being formed by a first portion (180) of the casting material arranged between the sensing electrode (170) and the bushing conductor (560), wherein the primary capacitor (150) is operable as a high-voltage capacitor in a high-voltage portion (370) of a sensing voltage divider (400) for sensing the elevated voltage of the bushing conductor (560);
d) a tubular shield electrode (190), embedded in the casting material, arranged coaxially around the sensing electrode (170), and insulated against the sensing electrode (170) by a second portion (182) of the casting material arranged between the sensing electrode (170) and the shield electrode (190);
e) a first spacer (200), embedded in the casting material and arranged radially between the sensing electrode (170) and the shield electrode(190),
wherein the first spacer (200) is mechanically connected to the sensing electrode (170) and to the shield electrode (190) to maintain the sensing electrode (170) and the shield electrode (190) in a fixed spatial relation to each other,
**characterized in that** the first spacer (200) comprises a flat major surface and is oriented such that a normal on the major surface is oriented parallel to a central axis (100) of the tubular sensing electrode (170) or to a central axis (100) of the tubular shield electrode (190).

2. Sensored bushing (1) according to claim 1, wherein the first spacer (200) is of annular shape and comprises a flat major surface delimited radially by an outer perimetral edge (290) and an inner perimetral edge (280), wherein the first spacer (200) is mechanically connected to the sensing electrode (170) at the inner perimetral edge (280), and wherein the first spacer (200) is mechanically connected to the shield electrode (190) at the outer perimetral edge (290).

3. Sensored bushing (1) according to claim 2, wherein the first spacer (200) comprises, on the major surface, a first conductive trace and a second conductive trace for respective electrical connection of electric or electronic components (210) mounted on the first spacer (200), and wherein the inner perimetral edge (280) comprises a conductive portion, said conductive portion being conductively connected with the first conductive trace and conductively connected with the sensing electrode (170),
and optionally wherein the outer perimetral edge (290) comprises a conductive portion, said conductive portion being conductively connected with the second conductive trace and conductively connected with the shield electrode (190).

4. Sensored bushing (1) according to any one of the preceding claims, wherein the first spacer (200) comprises one or more apertures (300) for allowing liquid casting material to flow from one side of the first spacer (200) through the one or more apertures (300) to the opposite side of the first spacer (200).

5. Sensored bushing (1) according to any one of the preceding claims, wherein the first spacer (200) is, or comprises, a printed circuit board (200), wherein the sensored bushing (1) further comprises a low-voltage capacitor (320) conductively connected with the sensing electrode (170) and mounted on the printed circuit board (200), wherein the low-voltage capacitor (320) is comprised in a low-voltage portion (380) of the sensing voltage divider (400) for sensing the elevated voltage of the bushing conductor (560), and wherein the primary capacitor (150) is comprised in a high-voltage portion (370) of the sensing voltage divider (400).

6. Sensored bushing (1) according to any one of the preceding claims, further comprising a second spacer, embedded in the casting material and arranged radially between the sensing electrode (170) and the shield electrode (190),
wherein the second spacer is mechanically connected to the sensing electrode (170) and to the shield electrode (190) to maintain the sensing electrode (170) and the shield electrode (190) in a fixed spatial relation to each other.

7. Sensored bushing (1) according to any one of the preceding claims, further comprising
a) a correction contact, accessible from outside the sensored bushing (1); and
b) a correction resistor (260) having a temperature-dependent electrical resistance for providing, at the correction contact, a correction signal which varies with a temperature of the casting material, wherein the correction resistor (260)
- is arranged in the bushing body (140);
- is thermally connected to the casting material; and
- is electrically connected to the correction contact.

8. Sensored bushing (1) according to claim 7, wherein the correction resistor (260) has a relative resistance temperature dependency of ΔR/R₀ > 1 x 10⁻⁴ per degree Celsius, where ΔR is the change in resistance between 0°C and 100°C, and R₀ is the resistance at 0°C.

9. Sensored bushing (1) according to claim 7 or claim 8, wherein the correction resistor (260) is arranged on the first spacer (200).

10. Sensored bushing (1) according to any one of the preceding claims, wherein the sensing electrode (170) comprises a mesh of conductive wires forming apertures between them.

11. Sensored bushing (1) according to any one of the preceding claims, further comprising
a) a signal contact (360), conductively connected to the sensing electrode (170) and arranged on an outer surface of the bushing body (140),
and optionally
b) a grounding contact (340), conductively connected to the shield electrode (190) and arranged on an outer surface of the bushing body (140).

12. Electrical apparatus (30), such as a switchgear (30) or a transformer, in a power distribution network of a national grid for distributing electrical power at medium or high voltages, the apparatus (30) comprising
a) a power conductor (35), such as a bus bar or a central conductor of a power cable, in the apparatus (30) for conducting the electrical power at currents of ten Ampère or more, and
b) a sensored bushing (1) according to any one of claims 1 to 11, wherein the power conductor (35) is electrically connected to the bushing conductor (560).

13. Power distribution network of a national grid for distributing electrical power at medium or high voltages, the network comprising an apparatus (30) according to claim 12.

14. Process of manufacturing a sensored bushing (1) for connecting a separable connector (10) to a switchgear (30) or to a transformer in a power distribution network of a national grid for distributing electrical power at medium or high voltages,
the sensored bushing (1) comprising
a) a bushing body (140);
b) an elongated bushing conductor (560), embedded in the bushing body (140), for conducting power at currents of ten Ampère or more, the length direction of the bushing conductor defining axial directions (110) and radial directions (120) orthogonal to the axial directions (110); and
c) an electrode assembly (270) embedded in the bushing body (140), arranged coaxially around the bushing conductor (560) and comprising
i) a tubular sensing electrode (170),
ii) a tubular shield electrode (190), arranged coaxially around the sensing electrode (170),
iii) a first spacer (200), arranged radially between the sensing electrode (170) and the shield electrode (190), and mechanically connected to the sensing electrode (170) and to the shield electrode (190) to maintain the sensing electrode (170) and the shield electrode (190) in a fixed spatial relation to each other; wherein the first spacer (200) comprises a flat major surface and is oriented such that a normal on the major surface is oriented parallel to a central axis (100) of the tubular sensing electrode (170) or to a central axis (100) of the tubular shield electrode (190);
wherein the process comprises
- arranging the electrode assembly (270) such that the sensing electrode (170) is arranged coaxially around the bushing conductor (560), and - previously or subsequently - arranging the bushing conductor (560) and the electrode assembly (270) in a mold;
- filling the mold with a liquid, electrically insulating, solidifiable casting material such that the bushing conductor (560) and the electrode assembly (270) are embedded in the casting material and such that portions (180, 182) of the casting material are arranged between the bushing conductor (560) and the sensing electrode (170) and between the sensing electrode (170) and the shield electrode (190);
- solidifying the casting material to form the bushing body (140) such that the bushing conductor (560) and the electrode assembly (270) are embedded in the casting material.

## Patentansprüche

1. Mit Sensoren versehene Durchführung (1) zum Verbinden eines trennbaren Verbinders (10) mit einer Schaltanlage (30) oder einem Transformator in einem Stromverteilungsnetz eines Überlandleitungsnetzes zum Verteilen von elektrischem Strom bei mittlerer oder hoher Spannung, die Durchführung (1) aufweisend
a) einen Durchführungskörper (140), aufweisend ein erstarrtes, elektrisch isolierendes Gussmaterial;
b) einen länglichen Durchführungsleiter (560), der in das Gussmaterial eingebettet ist, zum Leiten von Strom mit erhöhter Spannung und bei Strömen von zehn Ampere oder mehr in die Schaltanlage (30) oder den Transformator, wobei die Längsrichtung des Durchführungsleiters (560) eine Durchführungsachse (100) und axiale Richtungen (110) und radiale Richtungen (120) orthogonal zu der Durchführungsachse (100) definiert;
c) eine röhrenförmige Messelektrode (170), die in das Gussmaterial eingebettet und um den Durchführungsleiter (560) herum koaxial eingerichtet ist, wobei die Messelektrode (170) und der Durchführungsleiter (560) als Elektroden eines Primärkondensators (150) betriebsfähig sind, ein Dielektrikum des Primärkondensators (150) durch einen ersten Abschnitt (180) des Gussmaterials ausgebildet wird, der zwischen der Messelektrode (170) und dem Durchführungsleiter (560) eingerichtet ist, wobei der Primärkondensator (150) als ein Hochspannungskondensator in einem Hochspannungsabschnitt (370) eines Messspannungsteilers (400) zum Messen der erhöhten Spannung des Durchführungsleiters (560) betriebsfähig ist;
d) eine röhrenförmige Abschirmelektrode (190), die in das Gussmaterial eingebettet, um die Messelektrode (170) herum koaxial eingerichtet ist und durch einen zweiten Abschnitt (182) des Gussmaterials, der zwischen der Messelektrode (170) und der Abschirmelektrode (190) eingerichtet ist, gegenüber der Messelektrode (170) isoliert ist;
e) einen ersten Abstandshalter (200), der in das Gussmaterial eingebettet und radial zwischen der Messelektrode (170) und der Abschirmelektrode (190) eingerichtet ist, wobei der erste Abstandshalter (200) mit der Messelektrode (170) und mit der Abschirmelektrode (190) mechanisch verbunden ist, um die Messelektrode (170) und die Abschirmelektrode (190) in einer festen räumlichen Beziehung zueinander zu halten, **dadurch gekennzeichnet, dass** der erste Abstandshalter (200) eine flache Hauptoberfläche aufweist und derart ausgerichtet ist, dass eine Normale auf der Hauptoberfläche parallel zu einer Mittelachse (100) der röhrenförmigen Messelektrode (170) oder zu einer Mittelachse (100) der röhrenförmigen Abschirmelektrode (190) ausgerichtet ist.

2. Mit Sensoren versehene Durchführung (1) nach Anspruch 1, wobei der erste Abstandshalter (200) ringförmig ist und eine flache Hauptoberfläche aufweist, die durch eine äußere Umfangskante (290) und eine innere Umfangskante (280) radial begrenzt ist, wobei der erste Abstandshalter (200) an der inneren Umfangskante (280) mit der Messelektrode (170) mechanisch verbunden ist und wobei der erste Abstandshalter (200) an der äußeren Umfangskante (290) mit der Abschirmelektrode (190) mechanisch verbunden ist.

3. Mit Sensoren versehene Durchführung (1) nach Anspruch 2, wobei der erste Abstandshalter (200), auf der Hauptoberfläche, eine erste leitende Spur und eine zweite leitende Spur für eine jeweilige elektrische Verbindung von elektrischen oder elektronischen Komponenten (210) aufweist, die auf dem ersten Abstandshalter (200) montiert sind, und wobei die innere Umfangskante (280) einen leitenden Abschnitt aufweist, wobei der leitende Abschnitt mit der ersten leitende Spur leitend verbunden ist und mit der Messelektrode (170) leitend verbunden ist,
und gegebenenfalls wobei die äußere Umfangskante (290) einen leitenden Abschnitt aufweist, wobei der leitende Abschnitt mit der zweiten leitenden Spur leitend verbunden ist und mit der Abschirmelektrode (190) leitend verbunden ist.

4. Mit Sensoren versehene Durchführung (1) nach einem der vorstehenden Ansprüche, wobei der erste Abstandshalter (200) eine oder mehrere Öffnungen (300) zum Ermöglichen einem flüssigen Gussmaterial, von einer Seite des ersten Abstandshalters (200) durch die eine oder mehreren Öffnungen (300) hindurch zu der gegenüberliegenden Seite des ersten Abstandshalters (200) zufließen, aufweist.

5. Mit Sensoren versehene Durchführung (1) nach einem der vorstehenden Ansprüche, wobei der erste Abstandshalter (200) eine Leiterplatte (200) ist oder eine solche aufweist, wobei die mit Sensoren versehene Durchführung (1) ferner einen Niederspannungskondensator (320) aufweist, der mit der Messelektrode (170) leitend verbunden und auf der Leiterplatte (200) montiert ist, wobei der Niederspannungskondensator (320) in einem Niederspannungsabschnitt (380) des Messspannungsteilers (400) zum Messen der erhöhten Spannung des Durchführungsleiters (560) enthalten ist, und wobei der Primärkondensator (150) in einem Hochspannungsabschnitt (370) des Messspannungsteilers (400) enthalten ist.

6. Mit Sensoren versehene Durchführung (1) nach einem der vorstehenden Ansprüche, ferner aufweisend einen zweiten Abstandshalter, der in das Gussmaterial eingebettet und radial zwischen der Messelektrode (170) und der Abschirmelektrode (190) eingerichtet ist,
wobei der zweite Abstandshalter mit der Messelektrode (170) und der Abschirmelektrode (190) mechanisch verbunden ist, um die Messelektrode (170) und die Abschirmelektrode (190) in einer festen räumlichen Beziehung zueinander zu halten.

7. Mit Sensoren versehene Durchführung (1) nach einem der vorstehenden Ansprüche, ferner aufweisend
a) einen Korrekturkontakt, der von außerhalb der mit Sensoren versehenen Durchführung (1) zugänglich ist; und
b) einen Korrekturwiderstand (260), der einen temperaturabhängigen elektrischen Widerstandswert zum Bereitstellen, an dem Korrekturkontakt, eines Korrektursignals, das mit einer Temperatur des Gussmaterials variiert, aufweist, wobei der Korrekturwiderstand (260)
- in dem Durchführungskörper (140) eingerichtet ist;
- mit dem Gussmaterial thermisch verbunden ist; und
- mit dem Korrekturkontakt elektrisch verbunden ist.

8. Mit Sensoren versehene Durchführung (1) nach Anspruch 7, wobei der Korrekturwiderstand (260) eine relative Widerstandstemperaturabhängigkeit von ΔR/R₀ > 1 x 10⁻⁴ pro Grad Celsius aufweist, wobei ΔR die Widerstandsänderung zwischen 0 °C und 100 °C ist und R₀ der Widerstand bei 0 °C ist.

9. Mit Sensoren versehene Durchführung (1) nach Anspruch 7 oder 8, wobei der Korrekturwiderstand (260) auf dem ersten Abstandshalter (200) eingerichtet ist.

10. Mit Sensoren versehene Durchführung (1) nach einem der vorstehenden Ansprüche, wobei die Messelektrode (170) ein Netz aus leitenden Drähten aufweist, die zwischen sich Öffnungen ausbilden.

11. Mit Sensoren versehene Durchführung (1) nach einem der vorstehenden Ansprüche, ferner aufweisend
a) einen Signalkontakt (360), der mit der Messelektrode (170) leitend verbunden und auf einer Außenoberfläche des Durchführungskörpers (140) eingerichtet ist,
und gegebenenfalls
b) einen Erdungskontakt (340), der mit der Abschirmelektrode (190) leitend verbunden und auf einer Außenoberfläche des Durchführungskörpers (140) eingerichtet ist.

12. Elektrische Einrichtung (30), wie eine Schaltanlage (30) oder ein Transformator, in einem Stromverteilungsnetz eines Überlandleitungsnetzes zum Verteilen von elektrischem Strom bei mittlerer oder hoher Spannung, die Einrichtung (30) aufweisend
a) einen Stromleiter (35), wie eine Sammelschiene oder einen Mittelleiter eines Stromkabels, in der Einrichtung (30) zum Leiten des elektrischen Stroms bei Strömen von zehn Ampere oder mehr, und
b) eine mit Sensoren versehene Durchführung (1) nach einem der Ansprüche 1 bis 11, wobei der Stromleiter (35) mit dem Durchführungsleiter (560) elektrisch verbunden ist.

13. Stromverteilungsnetz eines Überlandleitungsnetzes zum Verteilen von elektrischem Strom bei mittlerer oder hoher Spannung, das Netz aufweisend eine Einrichtung (30) nach Anspruch 12.

14. Verfahren zum Herstellen einer mit Sensoren versehenen Durchführung (1) zum Verbinden eines trennbaren Verbinders (10) mit einer Schaltanlage (30) oder einem Transformator in einem Stromverteilungsnetz eines Überlandleitungsnetzes zum Verteilen von elektrischem Strom bei mittlerer oder hoher Spannung,
die mit Sensoren versehene Durchführung (1) aufweisend
a) einen Durchführungskörper (140);
b) einen länglichen Durchführungsleiter (560), der in den Durchführungskörper (140) eingebettet ist, zum Leiten von Strom bei Strömen von zehn Ampere oder mehr, wobei die Längsrichtung des Durchführungsleiters axiale Richtungen (110) und radiale Richtungen (120) orthogonal zu den axialen Richtungen (110) definiert; und
c) eine Elektrodenanordnung (270), die in den Durchführungskörper (140) eingebettet, um den Durchführungsleiter (560) herum koaxial eingerichtet ist und aufweisend
i) eine röhrenförmige Messelektrode (170),
ii) eine röhrenförmige Abschirmelektrode (190), die um die Messelektrode (170) herum koaxial eingerichtet ist,
iii) einen ersten Abstandshalter (200), der zwischen der Messelektrode (170) und der Abschirmelektrode (190) radial eingerichtet ist und mit der Messelektrode (170) und der Abschirmelektrode (190) mechanisch verbunden ist, um die Messelektrode (170) und die Abschirmelektrode (190) in einer festen räumlichen Beziehung zueinander zu halten; wobei der erste Abstandshalter (200) eine flache Hauptoberfläche aufweist und derart ausgerichtet ist, dass eine Normale auf der Hauptoberfläche parallel zu einer Mittelachse (100) der röhrenförmigen Messelektrode (170) oder zu einer Mittelachse (100) der röhrenförmigen Abschirmelektrode (190) ausgerichtet ist;
wobei der Prozess aufweist
- Einrichten der Elektrodenanordnung (270) derart, dass die Messelektrode (170) um den Durchführungsleiter (560) herum koaxial eingerichtet ist, und - zuvor oder anschließend - Einrichten des Durchführungsleiters (560) und der Elektrodenanordnung (270) in einer Form;
- derartiges Füllen der Form mit einem flüssigen, elektrisch isolierenden, verfestigbaren Gussmaterial, dass der Durchführungsleiter (560) und die Elektrodenanordnung (270) in dem Gussmaterial eingebettet sind und derart, dass Abschnitte (180, 182) des Gussmaterials zwischen dem Durchführungsleiter (560) und der Messelektrode (170) und zwischen der Messelektrode (170) und der Abschirmelektrode (190) eingerichtet sind;
- Verfestigen des Gussmaterials, um den Durchführungskörper (140) derart auszubilden, dass der Durchführungsleiter (560) und die Elektrodenanordnung (270) in das Gussmaterial eingebettet sind.

## Revendications

1. Traversée (1) à capteur destinée à connecter un connecteur séparable (10) à un appareillage de commutation (30) ou à un transformateur dans un réseau de distribution d'énergie d'un réseau national pour la distribution d'énergie électrique à moyennes ou hautes tensions, la traversée (1) comprenant
a) un corps de traversée (140) comprenant un matériau de moulage solidifié et électriquement isolant ;
b) un conducteur de traversée (560) allongé, intégré dans le matériau de moulage, destiné à conduire de l'énergie à une tension élevée et à des courants de dix ampères ou plus dans l'appareillage de commutation (30) ou le transformateur, la direction de longueur du conducteur de traversée (560) définissant un axe de traversée (100) et des directions axiales (110) et des directions radiales (120) orthogonales à l'axe de traversée (100) ;
c) une électrode de détection (170) tubulaire, intégrée dans le matériau de moulage et disposée coaxialement autour du conducteur de traversée (560), dans laquelle l'électrode de détection (170) et le conducteur de traversée (560) peuvent fonctionner en tant qu'électrodes d'un condensateur primaire (150), un diélectrique du condensateur primaire (150) étant formé par une première partie (180) du matériau de moulage disposée entre l'électrode de détection (170) et le conducteur de traversée (560), dans laquelle le condensateur primaire (150) peut fonctionner en tant que condensateur haute tension dans une partie haute tension (370) d'un diviseur de tension de détection (400) destiné à détecter la tension élevée du conducteur de traversée (560) ;
d) une électrode de protection (190) tubulaire, intégrée dans le matériau de moulage, disposée coaxialement autour de l'électrode de détection (170) et isolée de l'électrode de détection (170) par une seconde partie (182) du matériau de moulage disposée entre l'électrode de détection (170) et l'électrode de protection (190) ;
e) une première entretoise (200), intégrée dans le matériau de moulage et disposée radialement entre l'électrode de détection (170) et l'électrode de protection (190),
dans laquelle la première entretoise (200) est mécaniquement reliée à l'électrode de détection (170) et à l'électrode de protection (190) afin de maintenir l'électrode de détection (170) et l'électrode de protection (190) dans une relation spatiale fixe l'une par rapport à l'autre,
**caractérisée en ce que** la première entretoise (200) comprend une surface principale plane et est orientée de telle sorte qu'une normale à la surface principale est orientée parallèlement à un axe central (100) de l'électrode de détection (170) tubulaire ou à un axe central (100) de l'électrode de protection (190) tubulaire.

2. Traversée (1) à capteur selon la revendication 1, dans laquelle la première entretoise (200) est de forme annulaire et comprend une surface principale plane délimitée radialement par un bord périmétrique externe (290) et un bord périmétrique interne (280), dans laquelle la première entretoise (200) est mécaniquement reliée à l'électrode de détection (170) au niveau du bord périmétrique interne (280), et dans laquelle la première entretoise (200) est mécaniquement reliée à l'électrode de protection (190) au niveau du bord périmétrique externe (290).

3. Traversée (1) à capteur selon la revendication 2, dans laquelle la première entretoise (200) comprend, sur la surface principale, une première trace conductrice et une seconde trace conductrice pour la connexion électrique respective de composants (210) électriques ou électroniques montés sur la première entretoise (200), et dans laquelle le bord périmétrique interne (280) comprend une partie conductrice, ladite partie conductrice étant connectée de manière conductrice à la première trace conductrice et connectée de manière conductrice à l'électrode de détection (170),
et optionnellement, dans laquelle le bord périmétrique externe (290) comprend une partie conductrice, ladite partie conductrice étant connectée de manière conductrice à la seconde trace conductrice et connectée de manière conductrice à l'électrode de protection (190).

4. Traversée (1) à capteur selon l'une quelconque des revendications précédentes, dans laquelle la première entretoise (200) comprend une ou plusieurs ouvertures (300) destinées à permettre à un matériau de moulage liquide de s'écouler à partir d'un côté de la première entretoise (200), à travers la ou les ouvertures (300), vers le côté opposé de la première entretoise (200).

5. Traversée (1) à capteur selon l'une quelconque des revendications précédentes, dans laquelle la première entretoise (200) est, ou comprend, une carte de circuits imprimés (200), dans laquelle la traversée (1) à capteur comprend en outre un condensateur basse tension (320) connecté de manière conductrice à l'électrode de détection (170) et monté sur la carte de circuits imprimés (200), dans laquelle le condensateur basse tension (320) est compris dans une partie basse tension (380) du diviseur de tension de détection (400) destinée à détecter la tension élevée du conducteur de traversée (560), et dans laquelle le condensateur primaire (150) est compris dans une partie haute tension (370) du diviseur de tension de détection (400).

6. Traversée (1) à capteur selon l'une quelconque des revendications précédentes, comprenant en outre une seconde entretoise, intégrée dans le matériau de moulage et disposée radialement entre l'électrode de détection (170) et l'électrode de protection (190),
dans laquelle la seconde entretoise est mécaniquement reliée à l'électrode de détection (170) et à l'électrode de protection (190) afin de maintenir l'électrode de détection (170) et l'électrode de protection (190) dans une relation spatiale fixe l'une par rapport à l'autre.

7. Traversée (1) à capteur selon l'une quelconque des revendications précédentes, comprenant en outre
a) un contact de correction, accessible à partir de l'extérieur de la traversée (1) à capteur ; et
b) une résistance de correction (260) ayant une résistance électrique dépendant de la température destinée à fournir, au niveau du contact de correction, un signal de correction qui varie en fonction d'une température du matériau de moulage, dans laquelle la résistance de correction (260)
- est disposée dans le corps de la bague (140) ;
- est reliée thermiquement au matériau de moulage ; et
- est connectée électriquement au contact de correction.

8. Traversée (1) à capteur selon la revendication 7, dans laquelle la résistance de correction (260) a une dépendance à la température de résistance relative de ΔR/R₀ > 1 x 10⁻⁴ par degré Celsius, où ΔR est la variation de résistance comprise entre 0 °C et 100 °C, et R₀ est la résistance à 0 °C.

9. Traversée (1) à capteur selon la revendication 7 ou la revendication 8, dans laquelle la résistance de correction (260) est disposée sur la première entretoise (200).

10. Traversée (1) à capteur selon l'une quelconque des revendications précédentes, dans laquelle l'électrode de détection (170) comprend un treillis de fils conducteurs formant des ouvertures entre eux.

11. Traversée (1) à capteur selon l'une quelconque des revendications précédentes, comprenant en outre
a) un contact de signal (360), connecté de manière conductrice à l'électrode de détection (170) et disposé sur une surface externe du corps de traversée (140), et facultativement
b) un contact de terre (340), connecté de manière conductrice à l'électrode de protection (190) et disposé sur une surface externe du corps de traversée (140).

12. Appareil (30) électrique, tel qu'un appareillage de commutation (30) ou un transformateur, dans un réseau de distribution d'énergie d'un réseau national pour la distribution d'énergie électrique à moyennes ou hautes tensions, l'appareil (30) comprenant
a) un conducteur d'énergie (35), tel qu'une barre omnibus ou un conducteur central d'un câble d'énergie, dans l'appareil (30) destiné à conduire l'énergie électrique à des courants de dix ampères ou plus, et
b) une traversée (1) à capteur selon l'une quelconque des revendications 1 à 11, dans lequel le conducteur d'énergie (35) est connecté électriquement au conducteur de traversée (560).

13. Réseau de distribution d'énergie d'un réseau national pour la distribution d'énergie électrique à moyennes ou hautes tensions, le réseau comprenant un appareil (30) selon la revendication 12.

14. Procédé de fabrication d'une traversée (1) à capteur destinée à connecter un connecteur séparable (10) à un appareillage de commutation (30) ou à un transformateur dans un réseau de distribution d'énergie d'un réseau national pour la distribution d'énergie électrique à moyennes ou hautes tensions,
la traversée (1) à capteur comprenant
a) un corps de traversée (140) ;
b) un conducteur de traversée (560) allongé, intégré dans le corps de traversée (140), destiné à conduire de l'énergie à des courants de dix ampères ou plus, la direction de longueur du conducteur de traversée définissant des directions axiales (110) et des directions radiales (120) orthogonales aux directions axiales (110) ; et
c) un ensemble électrode (270) intégré dans le corps de traversée (140), disposé coaxialement autour du conducteur de traversée (560) et comprenant
i) une électrode de détection (170) tubulaire,
ii) une électrode de protection (190) tubulaire, disposée coaxialement autour de l'électrode de détection (170),
iii) une première entretoise (200), disposée radialement entre l'électrode de détection (170) et l'électrode de protection (190), et mécaniquement reliée à l'électrode de détection (170) et à l'électrode de protection (190) afin de maintenir l'électrode de détection (170) et l'électrode de protection (190) dans une relation spatiale fixe l'une par rapport à l'autre ; dans lequel la première entretoise (200) comprend une surface principale plane et est orientée de telle sorte qu'une normale à la surface principale est orientée parallèlement à un axe central (100) de l'électrode de détection (170) tubulaire ou à un axe central (100) de l'électrode de protection (190) tubulaire ;
dans lequel le procédé comprend
- la disposition de l'ensemble électrode (270) de telle sorte que l'électrode de détection (170) est disposée coaxialement autour du conducteur de traversée (560), et - préalablement ou ultérieurement - la disposition du conducteur de traversée (560) et de l'ensemble électrode (270) dans un moule ;
- le remplissage du moule d'un matériau de moulage liquide, électriquement isolant et solidifiable, de telle sorte que le conducteur de traversée (560) et l'ensemble électrode (270) sont intégrés dans le matériau de moulage et que des parties (180, 182) du matériau de moulage sont disposées entre le conducteur de traversée (560) et l'électrode de détection (170) et entre l'électrode de détection (170) et l'électrode de protection (190) ;
- la solidification du matériau de moulage afin de former le corps de traversée (140) de telle sorte que le conducteur de traversée (560) et l'ensemble électrode (270) sont intégrés dans le matériau de moulage.
